# EUROPEAN PATENT APPLICATION

(11) **EP 4 716 401 A1**
(43) Date of publication of application: **25.03.2026**
(21) Application number: 24202056.8
(22) Date of filing: 23.09.2024
(51) Int. Cl.: H10B 63/00, H10N 70/20

(54) **METHOD FOR MANUFACTURING A MEMRISTOR SYSTEM FOR A NEUROMORPHIC DEVICE**

(71) Applicant: RIJKSUNIVERSITEIT GRONINGEN, 9712 CP Groningen (NL)
(72) Inventor: BANERJEE, Tamalika, 9747 AD Groningen (NL)
(74) Representative: V.O.

(57) **Abstract**

The invention provides a method for manufacturing a memristor system for a neuromorphic device, including:
-providing a first substrate;
-depositing an epitaxial buffer layer on the first substrate;
-epitaxially depositing at least one memristor device layer, in particular a semiconductor oxide layer, on the buffer layer;
-removing the buffer layer, in particular by dissolving and/or etching the buffer layer, to provide a freestanding memristor device layer;
-manufacturing a memristor device cell structure in/from the memristor device layer;
-providing a second substrate;
- forming a first electrode structure on the second substrate;
-joining the freestanding memristor device layer onto the first electrode structure of the second substrate; and
-forming a second electrode structure on the memristor device cell structure.

## Description

The invention relates to a method for manufacturing a memristor system for a neuromorphic device.

### BACKGROUND OF THE INVENTION

Recently, scientific interest has significantly increased concerning manufacturing of neuromorphic devices. In particular, citing the publication "This Memristor Works Best When Stressed " by Dina Genika, 2 January 2024, IEEE Spectrum, memristors devices that can "remember" their resistance state after the device is shut off-can serve not only as digital memory but also as building blocks of the neuromorphic computers of the future. However, it's been challenging to build a device that meets the demands of large-scale manufacturability and cost-effectiveness.

Similarly, following from US2024127888, innovative deep learning networks and their unique deployment strategies that simultaneously consider both the high accuracy of artificial intelligence (AI) algorithms and the high performance of hardware implementations are increasingly sought, especially in resource-constrained edge applications. In deep neural networks, convolution is widely used to measure the similarity between input features and convolution filters, but it involves a large number of multiplications between floating-point values. See for example U.S. Pat. No. 10,740,671 which discloses convolutional neural networks using a resistive processing unit array and is based on a traditional convolutional neural network using multiplication operations in the resistive processing unit array. See Also U.S. Pat. No. 10,460,817, which describes the traditional multiplication-based (convolution-based) neural network using multi-level non-volatile memory (NVM) cells; and U.S. Pat. No. 9,646,243 which uses general resistive processing unit (RPU) arrays to deploy traditional CNN systems. As is mentioned in US888, Resistive Random Access Memory (RRAM)-based in-memory computing (IMC) is a promising way to fuel the next-generation of AI chips featuring high speed, low power and low latency. Therefore, the strategy of the cutting-edge addition/subtraction-based neural network (AdderNet)-based in-memory computing (IMC) AI accelerator, offers the full benefits of both addition/subtraction operation and a high degree of parallelism. US888 provides specially designed topology and the connection of the RRAM crossbar array and peripheral circuits in a way that allows two factors in different circuit-level dimensions to be operated in the same dimension in addition/subtraction operations..

Besides, it is known to manufacture RRAM memory devices as such, see for example US2015357567, which provides a structure and a method that can be used for forming a non-volatile resistive switching memory devices characterized by a suppression of current at low bias and a high measured ON/OFF resistance ratio. As is mentioned in this publication, non-volatile random access memory (RAM) devices such as ferroelectric RAM (Fe RAM), magneto-resistive RAM (MRAM), organic RAM (ORAM), and phase change RAM (PCRAM), among others, have been explored as next generation memory devices. These devices often require new materials and device structures to couple with silicon based devices to form a memory cell, which lack one or more key attributes. For example, Fe-RAM and MRAM devices have fast switching characteristics and good programming endurance, but their fabrication is not CMOS compatible and size is usually large. Switching for a PCRAM device uses Joules heating, which inherently has high power consumption. Organic RAM or ORAM is incompatible with large volume silicon based fabrication and device reliability is usually poor.

It is common knowledge that Resistive random-access memory (ReRAM or RRAM) is a type of non-volatile (NV) random-access (RAM) computer memory that works by changing the resistance across a dielectric solid-state material, often referred to as a memristor. A neuromorphic device generally includes a plurality of memristors (i.e. a system of memristors), for example at least 1000 memristors and preferably more, such as at least a million memristors. Information concerning application of a memristor for enabling cognitive network functions can also be found for example in the Survey ""On Memristors for Enabling Energy Efficient and Enhanced Cognitive Network Functions", Saleh and Koldehofe, IEEE Access Volume 10 2022, 2 December 2022.

Further, as follows e.g. from US10650308B2, electronic neuromorphic networks can be implemented to reproduce brain-like processing applications wherein principles of computation based on pattern learning and recognition are performed by neural models. The neural models use synapses or synaptic circuits to connect neurons to each other for exchanging signals. A single neuron is connected with thousands of other neurons between synapses.

As is mentioned before, a main problem of neuromorphic device development is that fabrication of known memristor components is not CMOS compatible.

Regarding CMOS (Complementary Metal-Oxide-Semiconductor) industry, fabrication of modern electronic chips is a planar process involving different layers of materials to be deposited and then removed and this is usually repeated in several sequences until the entire device and circuitry is realized. Since each deposited layer differs in their functionalities, this generally means utilizing different deposition tools which are capable of delivering precise thickness with perfect conformality on the previous layers or etched vias. This technology has been perfected over 3-4 decades for the most commonly used Si CMOS fab. However inflexibility i) on the material choice for such established fab lines, ii) on the annealing temperatures, and iii) importantly on the chosen substrates (usually only silicon substrates) severely restricts developing technology that could include other multifunctional materials that are important to the development of technologies for neuromorphic computing applications.

### SUMMARY OF THE INVENTION

The present invention aims to provide an improved method for manufacturing a memristor system for a neuromorphic device (e.g. an artificial neural network). In particular, the invention aims to provide a method for manufacturing a memristor system for a neuromorphic device that resolves or alleviates above-mentioned problems. Further, in particular, the invention aims to provide a method for manufacturing a memristor system for a neuromorphic device that can lead to increased device manufacturing throughput and respective decrease of device manufacturing costs.

The present invention is defined by the independent claims.

According to an aspect of the invention, there is provided a method for manufacturing a memristor system for a neuromorphic device, including:
- providing a first substrate;
- depositing an epitaxial buffer layer (in particular lattice matched) on the first substrate;
- epitaxially depositing at least one memristor device layer, in particular a semiconductor oxide layer, on the buffer layer;
- removing the buffer layer, in particular by dissolving and/or etching the buffer layer, to provide a freestanding memristor device layer;
- manufacturing a memristor device cell structure in/from the memristor device layer;
- providing a second substrate;
- forming a first (e.g. bottom) electrode structure on the second substrate;
- joining the freestanding memristor device layer onto the first electrode structure of the second substrate; and
- forming a second (e.g. top) electrode structure on the memristor device cell structure;
wherein the first electrode structure, the second electrode structure and the intermediate memristor device cell structure are mutually aligned to form a memristor system.

In this way, a memristor system (in particular including a plurality memristors, e.g. including a plurality of arrays of memristors) can be manufactured efficiently, and particularly at a cost-effective manner, more particularly using CMOS-compatible manufacturing tools during part of the process. This in particular holds in case the second substrate is a CMOS-compatible substrate (wherein the first substrate is not a CMOS-compatible substrate). In that latter case, device manufacturing steps that are carried out on the second substrate (such as depositing the electrode structures) can be carried out in a CMOS-compatible environment (e.g. a CMOS-compatible cleanroom, a CMOS-Fab and/or the like). Device manufacturing steps that are carried out on the first substrate, in particular the depositing of the epitaxial buffer layer (in particular lattice matched) on the first substrate as well as the epitaxially depositing of the at least one memristor device layer on the buffer layer, can be carried out elsewhere, for example outside (externally of) said CMOS-compatible cleanroom, and optionally in another (CMOS-incompatible) cleanroom, or another processing space, that is separate from said CMOS-compatible cleanroom (to avoid contamination by CMOS-incompatible matter that can be present in the CMOS-incompatible cleanroom).

Further, an aspect of the invention provides a neuromorphic device including at least one memristor system manufactured by a method according to the invention.

In this way, above-mentioned advantages can be achieved.

Further features, effects and details of the invention appear from the detailed description and the drawings.

### BRIEF DESCRIPTION OF THE DRAWINGS

Figure 1 schematically shows a side view of a first step of a non-limiting embodiment of the invention;
Figure 2 schematically shows a side view of a second step of a non-limiting embodiment of the invention;
Figure 3 schematically shows a side view of a third step of a non-limiting embodiment of the invention;
Figure 4 schematically shows a side view of a fourth step of a non-limiting embodiment of the invention;
Figure 5A schematically shows a side view of a result of a said fourth step of a non-limiting embodiment of the invention;
Figure 5B schematically shows a perspective view of part of a further example;
Figure 6 schematically shows a perspective view of part of a fifth step of a non-limiting embodiment of the invention;
Figure 7 schematically shows a perspective view of a further part the fifth step of a non-limiting embodiment of the invention;
Figure 8 schematically shows a perspective view of a further part the fifth step of a non-limiting embodiment of the invention;
Figure 9A schematically shows a cross-sectional view of a result of the above-mentioned sixth step of a non-limiting embodiment of the invention;
Figure 9B a detail Q of Fig. 9A;
Figure 10 schematically shows a side view of a seventh step of a non-limiting embodiment of the invention;
Figure 11 schematically shows a side view of an eighth step of a non-limiting embodiment of the invention;
Figure 12 schematically shows a side view of a device structure following from a ninth step of a non-limiting embodiment of the invention;
Figure 13 schematically shows an opened perspective view of a detail of the device structure shown in Figure 12;
Figure 14 schematically shows am opened top view of part of the device structure shown in Figure 12; and
Figure 15 schematically shows a processing space arrangement according to a non-limiting embodiment of the invention.

### DETAILED DESCRIPTION

The invention is further described with reference to examples of methods according to the invention.

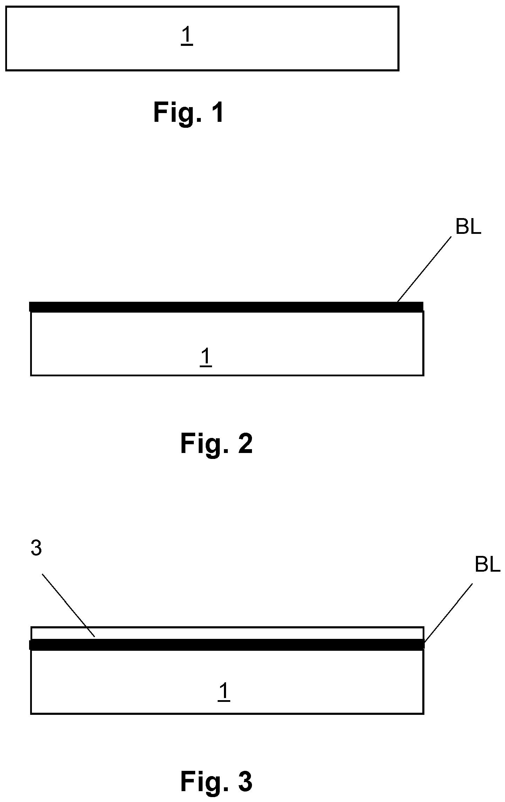

Figures 1-12 schematically depict various steps of a method for manufacturing a memristor system for a neuromorphic device. It should be observed that the various steps can be carried out in various ways and various sequences, as will be appreciated by the skilled person.

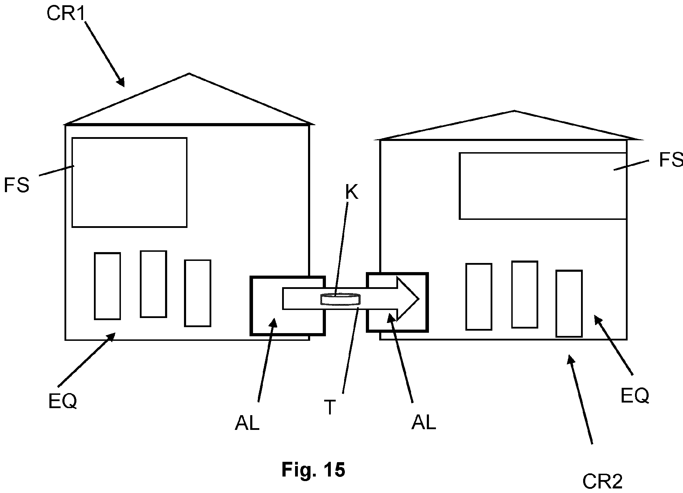

According an embodiment, the method includes providing a first substrate 1 (see Fig. 1). The providing of the first substrate, and further processing thereof, can e.g. be carried out in at least one first processing space, which may be a cleanroom environment CR1 (see Figure 15) or a different type of processing space.

According to a preferred embodiment, the first substrate 1 is selected from the group consisting of: a Strontium titanate (SrTiOs) substrate, a Lanthanum aluminate (LaAlOs) substrate and a Neodymium Gallate (NdGaOs) substrate.

Generally, the first substrate 1 can be a flat, crystalline substrate (e.g. having a substrate thickness of about 0.5 mm or smaller). In particular, the first substrate is a wafer or wafer-type substrate (known per-se).

According to an embodiment (see Figure 2), the method further includes depositing at least one epitaxial buffer layer BL (which can also be called an sacrificial layer) on the first substrate 1. In particular, the buffer layer BL is lattice matched to a crystal lattice structure of the first substrate 1.

A thickness of the at least one buffer layer BL (measured normally with respect to a surface of the substrate 1 that receives the buffer layer) can e.g. be smaller than 1 micron, e.g. about 100 nm or smaller, for example a thickness smaller than 40 nm, e.g. in the range of 10 - 20 nm.

As will be appreciated, deposition of the or each buffer layer BL can be achieved in various ways, for example using molecular beam epitaxy (MBE), physical vapor deposition (PVD), and/or the-like. Further, generally, respective epitaxial deposition is carried out (in a deposition chamber) under ultra-high vacuum conditions, in particular at a base chamber pressure of a respective epitaxy deposition tool of less than 10⁻⁸ mbar, for example a base chamber pressure of at most 10⁻⁹ mbar.

For example, the epitaxy deposition tool can be a physical vapor deposition tool (known per se) that uses a pulsed laser of a specific wavelength and energy density. This laser plume ablates material from a target forming a plasma of the target material which is then deposited on the substrate of our choice. A pre-ablation procedure can be carried out to ensure the removal of undesirable adsorbed materials. Also, the deposition tool can include a mechanical shutter over a target carousel to prevent any plasma generated during pre-ablation from depositing on the substrate 1. A multitarget carousel can be applied to allow targets of different materials to be accessed without repeated venting of the deposition chamber. Preferably, the deposition tool is equipped with an in-situ analysis tool that monitors the kinetics of the growth and thickness in real time.

Preferably (as will be clear to the skilled person), each substrate 1 is cleaned before deposition of the epitaxial layer(s), for example using an (established) chemical treatment protocol. This can e.g. include is a wet etching procedure (including e.g. optimization of etch time and annealing time depending on the received substrates and a miscut angle). Thereafter, preferably, optical inspection and inspection with e.g. Atomic Force microscopy is carried out to establish the roughness of a starting substrate surface at the nanometer level. The treated substrate(s) 1 can be transferred into an epitaxy deposition tool, e.g. using a substrate transfer assembly, at an appropriate base vacuum pressure (as mentioned above).

Further, an embodiment includes epitaxially depositing at least one memristor device layer 3, in particular a semiconductor oxide layer, on the (deposited) buffer layer BL, as is shown in Figure 3. In particular, the device layer(s) 3 is/are lattice matched to a the buffer layer(s) BL.

It will be clear that various materials can be used to form the memristor device layer(s) 3.

For example, good results can be achieved in case the at least one memristor device layer 3 includes a (doped) Strontium titanate (STO or SrTiOs) layer, for example a heterostructure including SrTiOs, in particular with at least one lanthanum strontium manganite (La₁₋ₓSrₓMnO₃) layer (e.g. La_{0.7}Sr_{0.3}MnO₃), e.g. a heterostructure of SrTiOs and La₁₋ₓSrₓMnO₃.

Alternatively, the at least one memristor device layer 3 can include a barium titanate (BaTiOs) layer, for example a heterostructure including BaTiOs, in particular with at least one lanthanum strontium manganite (La₁₋ₓSrₓMnO₃) layer (e.g. La_{0.7}Sr_{0.3}MnO₃), e.g. a heterostructure of BaTiOs and La₁₋ₓSrₓMnO₃.

Alternatively, the at least one memristor device layer 3 can include a hafnium oxide (HfOₓ) layer, for example a heterostructure including HfOₓ particular with at least one lanthanum strontium manganite (La₁₋ₓSrₓMnO₃) layer (e.g. La_{0.7}Sr_{0.3}MnO₃), e.g. a heterostructure of HfOₓ and La₁₋ₓSrₓMnO₃.

The deposition of the or each memristor device layer 3 can e.g. be carried out in the same deposition tool that is used for deposition said buffer layer(s) BL, or in a different (separate) deposition tool. It follows e.g. that deposition of the or each device 3 can be achieved in various ways, for example using molecular beam epitaxy (MBE), physical vapor deposition (PVD), and/or the-like. Further, generally, respective epitaxial deposition is carried out under ultra high vacuum conditions, in particular at a base pressure of a respective epitaxy deposition tool of less than 10⁻⁸ mbar, for example a base chamber pressure of at most 10⁻⁹ mbar.

A thickness of the at least one device layer 3 (measured normally with respect to a surface of the substrate 1 that receives the device layer 3) can e.g. be smaller than 50 nm, e.g. a thickness in the range of 10 - 30 nm.

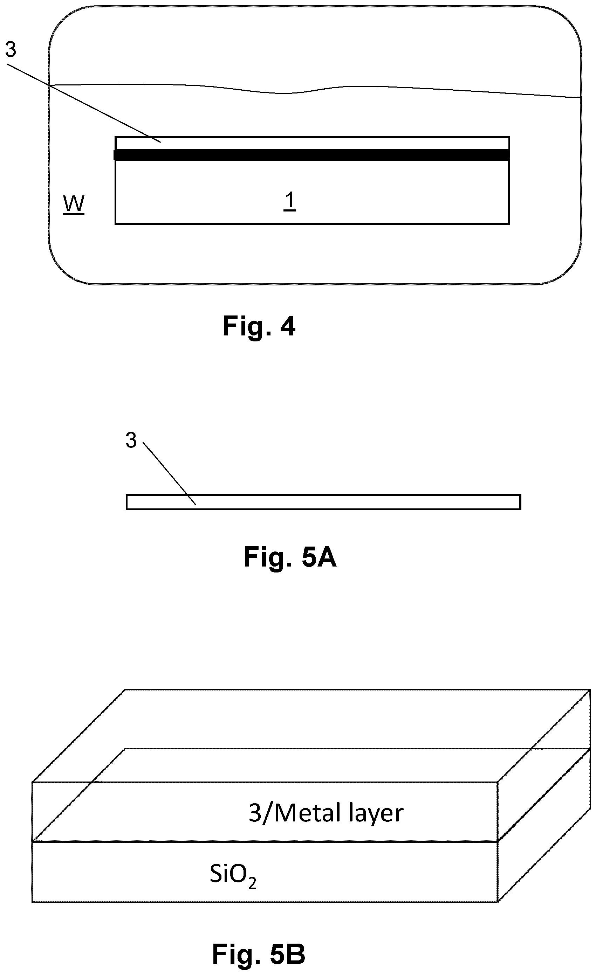

Further, an embodiment includes removing the buffer layer BL, in particular by dissolving and/or etching the buffer layer BL, to provide a freestanding memristor device layer 3. This is depicted, schematically, in Figures 4 and 5 (figure 5A showing the resulting freestanding device layer 3, which can include a single device layer or a plurality of layers in case of a heterostructure).

For example, removing the buffer layer BL can include providing a bath of liquid W (see fig. 4) to remove the buffer layer BL. In particular, the substrate 1 and respective epitaxial layers BL, 3 are submerged in the liquid during a predetermined processing period, to remove (e.g. dissolve) the buffer layer BL.

The removing of the buffer layer BL can also carried be out in a said first processing space CR1, or may be carried out in another (second) processing space CR2.

According to a preferred embodiment, the buffer layer BL is water soluble, for example a water soluble oxide (for example a buffer layer that consists of or includes Sr₃Al₂O₆), and is preferably removed by applying water W (in particular de-ionized water). It has been found that this can lead to good results, achieving a freestanding device layer (film) 3 that can retain desired memristor device properties. In particular, the resulting freestanding layer 3 can provide atomically flat surfaces (facing away from each other) for connecting to respective electrode structures 2, 4 (see below). Also, the resulting freestanding device layer (film) 3 can have an atomically constant thickness.

Good results are achieved in case the buffer layer is dissolved during a relatively long processing period. For example, the processing period (which can be the period during which the substrate 1 carrying the buffer layer BL and device layer 3 is submerged in processing liquid W) can be at least 24h, for example at least 48h, in particular at most 72h.

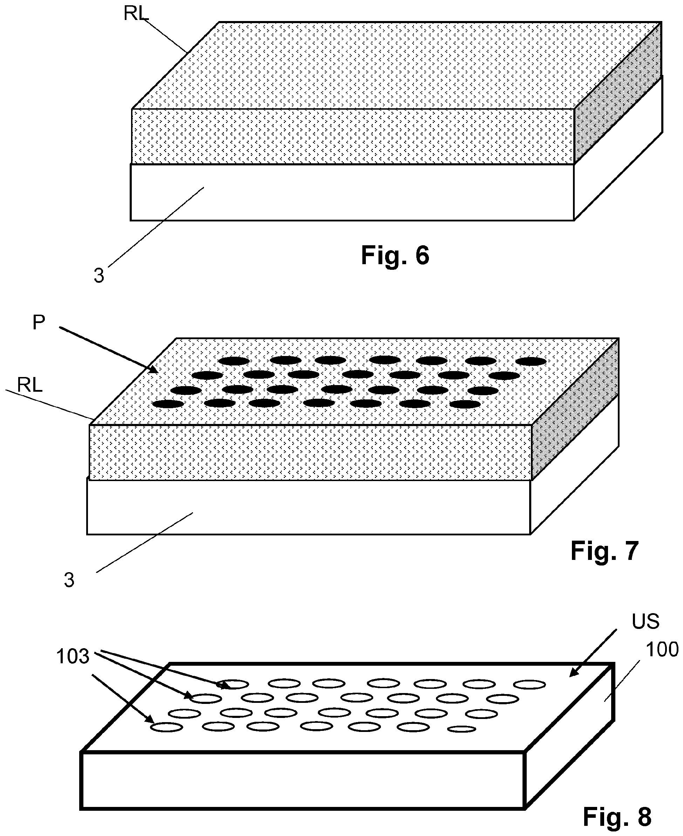

Further, the freestanding (loose, separated) device layer 3 is processed to manufacture a memristor device cell structure 103 therein (or therefrom). This can be achieved for example using a lithographic process, in particular using at least a photosensitive resist layer RL covering the memristor device layer 3 and transferring a device pattern P to the resist layer (in particular using radiation; patterning the resist layer with the pattern P). For example, the device pattern can be or include one or more arrays P of separate dots, for defining respective memristor device cells 103. This is shown schematically in Figures 6 and 7 (showing part of the respective layers 3). The lithographic process can e.g. include or be followed by etching away (any) sections of the device layer 3 located between the individual memristor device cells 103, and filling resulting gaps with electrically insulating material 100 (which can include e.g. silicon oxide, or any other suitable electrically insulating material). In a non-limiting embodiment the etching is carried out by a dry etching technique, for example Reactive Ion etching of Ion Beam etching.

According to an embodiment, the memristor device cell structure 103 (and any optional additional first circuit structure CE) is manufactured directly in/from the freestanding memristor device layer 3, in particular resulting in a freestanding (partly insulating) layer 100. The resulting (partly insulating) freestanding device layer 100 can then be applied onto a first electrode structure (see below).

Alternatively, the memristor device cell structure 103 (and any optional additional first circuit structure CE) can be manufactured in/from the memristor device layer 3 after the layer 3 has been applied onto a (insulating) substrate. For example, according to an embodiment, the freestanding memristor device layer 3 can be placed on a substrate, for example an insulating substrate, e.g. SiO₂ substrate, and a photosensitive resist layer can be applied. Further, according to an embodiment, a (thin) metallic layer (such as Co, e.g. 10 nm Co, followed by Au, e.g. 20 nm Au) can be deposited (for example using thermal evaporation) onto the freestanding memristor device layer 3. A result is schematically shown in Figure 5B. It will be appreciated that a lithographic process can then be applied, (this can be both dry etching or RIE), and etching the device layer 3 and metal layer, to form the isolated memristive device cells.

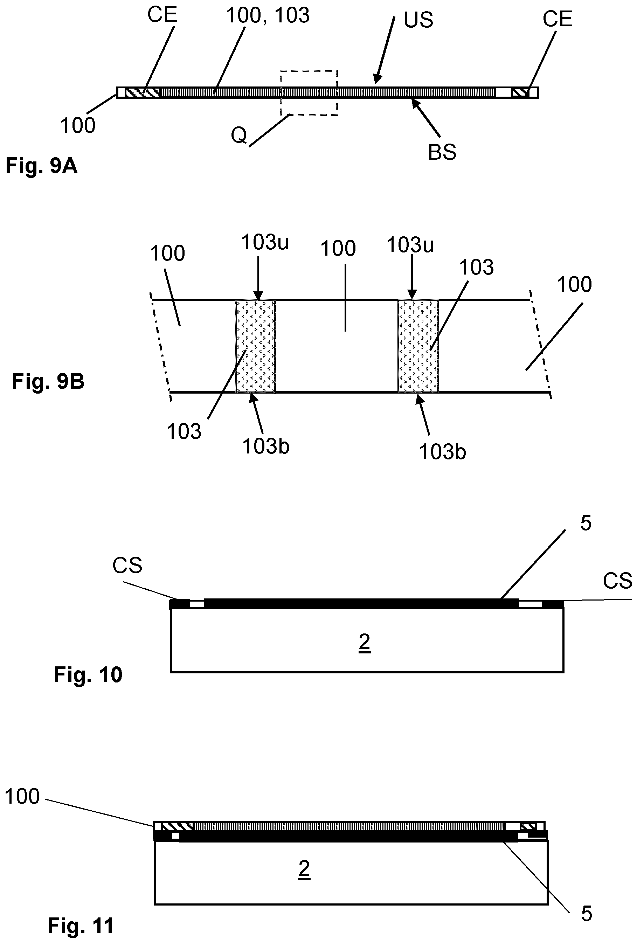

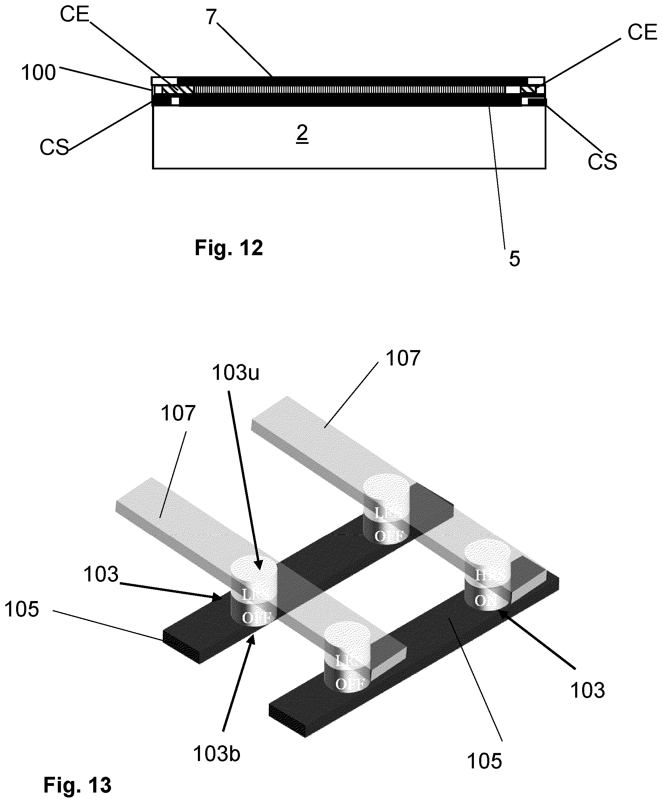

Figure 8 schematically shows a resulting thin freestanding (partly insulating) layer 100. The resulting freestanding, partly insulating, layer 100 includes the plurality of separate memristor device cells 103 (e.g. being provided in an orthogonal layout, of parallel rows). In particular, each of the memristor device cells 103 is separated by an insulating (e.g. SiO2) layer, providing respective upper contact cell sections 103u in an upper surface US of the freestanding layer 100 and bottom contact cell sections 103b in a bottom surface BS of the freestanding layer 100 (see also Fig. 13). Each of the individual device cells 103 consists of the material(s) of the initial memristor device layer(s) 3. The cells 103 are mutually separated by intermediate insulating material of the layer 100 (see Figures 8, 9A, 9B).

Preferably, the freestanding (loose, separated) device layer 3 is also processed to manufacture one or more additional first electronic circuit structures CE (optionally as part of a VLSI circuit) therein, for example one or more additional first electronic circuit structures CE that are connected to (or are to be connected to) the memristor cell system 103 (in particular to provide a neuromorphic memristor system). Such additional first electronic circuit structures CE are known per se and can include e.g. electronic switching elements, transistor structures, inductor structures, capacitor structures, resistor structures, and/or the like, as will be clear to the skilled person. In the drawings, the additional first electronic circuit structures CE have been shown to be present in the freestanding layer 100 around an intermediate memristor cell section 103, or along a lateral edge of the freestanding layer 100, but that is not required. The layout or arrangement can also be different, as will be appreciated by the skilled person, for example in case one or more additional first electronic circuit structures CE are provided (in the freestanding layer 100) between a number of memristor cell sections 103, and/or e.g. remote from a lateral edge of the freestanding layer 100.

It should be observed that the photosensitive resist layer RL can e.g. be applied after the buffer layer BL has been removed from the device layer (depending e.g. on the device application).

As is mentioned before, optionally, the memristor device cell structure 103 (and any optional additional first circuit structure CE) is manufactured in/from the memristor device layer 3 before the resulting freestanding device layer 100 is applied onto a first electrode structure (see below).

Further, for example, at least one step of a respective lithographic process can be carried out before the freestanding memristor device layer is applied onto the first electrode structure.

Regarding the lithographic process that is used, for example, maskless lithography is applied.

Figure 10 shows a further step, which includes providing a second substrate 2. Preferably, the second substrate 2 is a CMOS-compatible substrate, for example a silicon substrate or silicon-oxide substrate, e.g. an oxide coated silicon substrate. The providing of the second substrate, and further processing thereof, can e.g. be carried out in a second processing space environment CR2 (see Figure 15), which can be a CMOS-compatible cleanroom environment.

According to an embodiment, a first (bottom) electrode structure 5 is formed on the second substrate 2 (see Fig. 10). According to an embodiment, the first electrode structure 5 includes an array of parallel (spaced-apart) electrodes 105, in particular being spaced-apart to match a spacing-apart of the device cells 103 in the insulating layer 100 in a first direction (see also Fig. 13).

Further, the freestanding memristor device layer, in particular the insulating layer 100 having the device cell structure 103, is joined with the first electrode structure 5 of the second substrate 2 (see Figure 11). In particular, the device cells 103 are aligned with and connected to the respective electrodes 105 of the bottom electrode structure.

Finally, a second (top) electrode structure 7 is formed on the memristor device cell structure 103. According to an embodiment, the second electrode structure 7 includes an array of parallel (spaced-apart) electrodes 107, in particular being spaced-apart to match a spacing-apart of the device cells 103 in the device (cell) layer 100 in a second direction (the second direction being different from said first direction, wherein the first and second direction are in particular mutually orthogonal directions).

The first electrode structure 5 (i.e. the respective electrodes 105), the second electrode structure 7 (i.e. the respective electrodes 107) and the intermediate memristor device cell structure 103 are mutually aligned to form a memristor system. To this aim, in particular, the respective bottom contact cell sections 103b of the cells 103 can be aligned with and (electrically) connected to respective bottom electrodes 105, and the respective upper contact cell sections 103u can be aligned with and (electrically) connected to the upper electrodes 107.

Preferably, as follows from Figure 13 which shows a detail of the resulting memristor cell system, the first and second electrode structures 5, 7 form a cross-bar structure, the first electrode structure 5 in particular providing a word line structure and the second electrode structure 7 in particular providing a respective bitline structure or vice-versa. A crossbar architecture for resistive memories is known per se, and the respective memristor system can e.g. be called a "memristor crossbar", "memristor crossbar system" or "memristor crossbar structure"). In particular, the cross-bar electrode array can provide perpendicular conductive wordlines (rows) and respective bitlines (columns), where a memory element (i.e. a memristor device cell) exists at the intersection between each row and column. As will be appreciated by the skilled person, each memristor cell can be accessed for read and write by biasing the corresponding wordline and bitline.

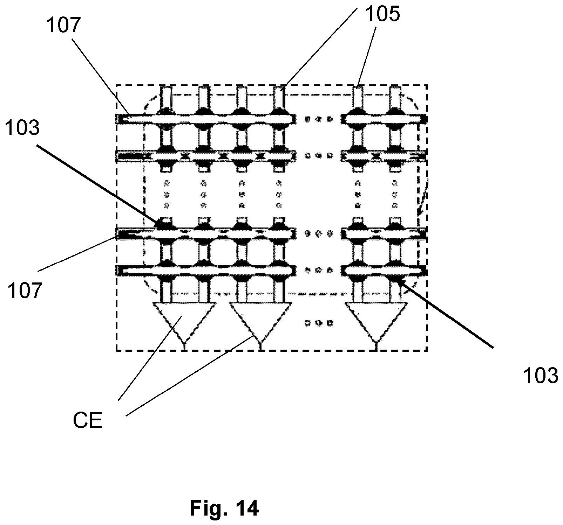

For example, an array of such crossbar structures includes a plurality of parallel top electrodes 107 and a plurality of parallel bottom electrodes 105 with respective switching elements (i.e. the memristor device cell elements 103) in between the intersection regions of the top electrodes 7 and the bottom electrodes 5. This is depicted in Figures 13, 14.

It should be noted that optionally, the second substrate 2 can (also) be provided with one or more additional (second) electronic circuit structures CS (optionally as part of a VLSI circuit), for example arranged to be connected to the memristor system 103, and/or e.g. to one or more additional -optional- electronic circuit structures CE present in the respective device layer 100. Such additional second electronic circuit structures CS are known per se and can include e.g. electronic switching elements, transistor structures, inductor structures, capacitor structures, resistor structures, and/or the like, as will be clear to the skilled person.

Such one or more additional electronic circuit structures CS can e.g. also be fabricated onto the second substrate in a said second processing space CR2.

Further, according to an embodiment, the one or more additional first and/or second electronic circuit structures CE, CS can be configured to provide programming and/or adjusting (e.g. writing) memristor states of each of the cells 103 of the memristor system.

Further, according to an embodiment, the one or more additional first and/or second electronic circuit structures CE, CS can be configured to receive or read information (for example from an external information provider) for programming and/or adjusting (e.g. writing) memristor states of each of the cells 103 of the memristor system.

Further, according to an embodiment, the one or more additional first and/or second electronic circuit structures CE, CS can be configured to read information from the memristor system 103.

Also, according to an embodiment, the one or more additional first and/or second electronic circuit structures CE, CS can be configured to transmit information, read from the memristor system 103, to an (integrated or external) information processor. For example, such an information processor can be configured to electronically interact with the memristor system 103 (in particular via respective electrodes 105, 107), for reading and/or writing respective memristor cell states. In case the information processor is an integrated processor, it can be part of the one or more additional electronic circuit structures CE, CS.

According to an embodiment, the memristor system 103 can be part of a neural network (i.e. an electronic neuromorphic network). In particular, the one or more first and/or second additional electronic circuit structures CE, CS can be configured to implement or provide a neural model, or at least part of a neural model, using or providing synapses or synaptic circuits to connect neurons to each other for exchanging signals.

In other words, it follows that the resulting device structure (part of which is shown in Figures 13 and 14) can in particular provide a memristor system, having a plurality of memristor cells 103 (in particular arrays of memristors that can be individually addressed via the respective electrode structures 5, 7). Advantageously, one or more of these memristor systems are applied in a neuromorphic device, for example to provide a respective neural network.

As follows from the above, preferably, the method includes:
- first processing space depositing the epitaxial buffer layer BL (for example in a first processing space CR1) on the first substrate 1 and depositing of the at least one memristor device layer 3 on the buffer layer BL; and
- depositing at least one of the electrode structures 5, 7 (for example each of the electrode structures 5, 7) in at least one second processing space CR2.

Optionally, the or each first processing space CR1 can be a first cleanroom, or a different type of processing space. Further, it is preferred that the second processing space CR2 is a CMOS-compatible cleanroom (i.e. a CMOS-compatible cleanroom environment).

Figure 15 schematically shows an example of a respective processing space arrangement. It should be observed that one or more first processing spaces CR1 and one or more second processing spaces CR2 can be applied. A first processing space CR1 and respective second processing space CR2 are preferably physically separate cleanrooms. Each second processing space CR2 in particular is a CMOS-compatible cleanroom (for example being part of a CMOS-compatible Fab). Further, each first processing space CR1 does not have to be a CMOS-compatible cleanroom, in particular in view of processing of the one or more first substrates 1 that generally do not have to be CMOS-compatible substrates. The first and second processing space CR1, CR2 can be located in spaced-apart (remote) structures or buildings, but that is not required.

Cleanrooms are commonly known. Each processing space CR1, CR2 can e.g. include an air conditioning system FS for actively cleaning processing space air. For example, a said second processing space CR2 can be include an ISO 14644-1 level 7 certified cleanroom and preferably an ISO 14644-1 level 6 certified cleanroom, or better, as well as one or more airlocks AL for transferring products between the cleanroom interior and an environment thereof. Further, a said processing space CR1, CR2 generally includes respective processing equipment EQ for achieving desired (afore-mentioned) manufacturing steps, for example substrate cleaning equipment, substrate handling systems, one or more deposition tools, process monitoring units, test equipment and/or the-like.

Preferably at least one airlock AL is arranged for entry into the second processing space, CR2, e.g. between the first processing space CR1 and the second processing space CR2. As part of a said manufacturing process, a device layer 3 (e.g. still placed on a respective substrate 1 and buffer layer BL) is preferably transferred from the first processing space CR1 to the second processing space CR2 via the at least one (intermediate) airlock AL, for example using a sealed container K (see Fig. 15). Transport of the device layer 3 (and respective container K) is indicated by arrow T in the drawing. Further, optionally, transport can include moving a manufactured layer 3 into a container K and sealing the container within the first processing space CR1, and opening the container K and removing the layer 3 from that container K within the second processing space CR2.

In case of mass production, it is preferred that a plurality of device layers 3 (i.e. a batch) is prepared in the first processing space CR1, wherein the plurality of memristor device layers 3 can be transferred jointly to the second (preferably CMOS-compatible) processing space CR2 to be processed further. For example, an afore-mentioned container K can be configured to transfer a batch of manufactured memristor device layers 3 into the second processing space CR2.

Alternatively, the first processing space CR1 can be integrated with or be part of the second processing space CR2, wherein transfer of the manufactured device layers 3 can e.g. be carried out via an intermediate airlock and/or via sealed containers K, as will be appreciated by the skilled person..

It follows that embodiments of the present invention can provide a technology platform that open the possibilities to include different materials and importantly on diverse substrates, in particular removing the restriction to the usage of only Si. Efficient bulk manufacturing of memristor systems for a neuromorphic devices can be provided, in particular providing integration with CMOS-compatible production facilities. Moreover, in case the freestanding layer 100 is manufactured to include both memristor device cells 103 and further (additional) first electronic circuit structures CE, sneak-path problems can be solved or alleviated.

Herein, the invention is described with reference to specific examples of embodiments of the invention. It will, however, be evident that various modifications and changes may be made therein, without departing from the essence of the invention. For the purpose of clarity and a concise description features are described herein as part of the same or separate embodiments, however, alternative embodiments having combinations of all or some of the features described in these separate embodiments are also envisaged.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean `at least one', and do not exclude a plurality. The mere fact that certain measures are recited in mutually different claims does not indicate that a combination of these measures cannot be used to an advantage.

It will for example be understood that the memristor system can be applied in a neuromorphic device (e.g. to form a neural network, or part of a neural network), but also in any other type of devices that requires such a memristor system.

Further, for example, removing the device layer 3 from the first substrate 1 can include application of an additional support layer, for example a polymer support (which can e.g. be spin coated on the top of the respective device film/heterostructure 3). This can be is followed by dissolution for release of the film (i.e. by removing the buffer layer BL).

Further, after each batch of films/heterostructure production, several characterization facilities (X-ray, physical property measurement set up PPMS) can be used (e.g. within a said first processing space CR1) to verify that the needed physical properties of the films have been realized.

## Claims

1. Method for manufacturing a memristor system for a neuromorphic device, including:
- providing a first substrate;
- depositing an epitaxial buffer layer on the first substrate;
- epitaxially depositing at least one memristor device layer, in particular a semiconductor oxide layer, on the buffer layer;
- removing the buffer layer, in particular by dissolving and/or etching the buffer layer, to provide a freestanding memristor device layer;
- manufacturing a memristor device cell structure in the memristor device layer;
- providing a second substrate;- forming a first electrode structure on the second substrate;
- joining the freestanding memristor device layer onto the first electrode structure of the second substrate; and
- forming a second *(top)* electrode structure on the memristor device cell structure;
wherein the first electrode structure, the second electrode structure and the intermediate memristor device cell structure are mutually aligned to form a memristor system.

2. The method according to claim 1, wherein the first and second electrode structures form a cross-bar structure, the first electrode structure in particular providing a word line structure and the second electrode structure in particular providing a respective bitline structure or vice-versa.

3. The method according to claim 1 or 2, wherein the memristor device cell structure is manufactured before the freestanding memristor device layer is applied onto the first electrode structure.

4. The method according to any of the preceding claims, wherein the memristor device cell structure is manufactured by a lithographic process, using at least a photosensitive resist layer covering the memristor device layer and transferring a device pattern to the resist layer.

5. The method according to claim 4, wherein at least one step of the lithographic process is carried out before the freestanding memristor device layer is applied onto the first electrode structure.

6. The method according to any of the preceding claims, wherein the first substrate is selected from the group consisting of: a Strontium titanate (SrTiOs) substrate, a Lanthanum aluminate (LaAlOs) substrate and a Neodymium Gallate (NdGaOs) substrate.

7. The method according to any of the preceding claims, wherein the buffer layer is water soluble, for example a water soluble oxide, and is preferably removed by applying water, in particular de-ionized water.

8. The method according to any of the preceding claims, wherein the buffer layer includes Sr₃Al₂O₆.

9. The method according to any of the preceding claims, wherein the buffer layer is dissolved during a processing period of at least 24h, for example at least 48h, in particular at most 72h.

10. The method according to any of the preceding claims, wherein the at least one memristor device layer is a heterostructure.

11. The method according to any of the preceding claims, wherein the at least one memristor device layer includes a Strontium titanate (STO or SrTiOs) layer, for example a heterostructure including SrTiOs, in particular with at least one lanthanum strontium manganite (La₁₋ₓSrₓMnO₃) layer (e.g. La_{0.7}Sr_{0.3}MnO₃), e.g. a heterostructure of SrTiOs and La₁₋ₓSrₓMnO₃.

12. The method according to any of the claims 1-11, wherein the at least one memristor device layer includes a barium titanate (BaTiOs) layer, for example a heterostructure including BaTiOs, in particular with at least one lanthanum strontium manganite (La₁₋ₓSrₓMnO₃) layer (e.g. La_{0.7}Sr_{0.3}MnO₃), e.g. a heterostructure of BaTiOs and La₁₋ₓSrₓMnO₃.

13. The method according to any of the claims 1-11, wherein the at least one memristor device layer includes a hafnium oxide (HfOₓ) layer, for example a heterostructure including HfOₓ particular with at least one lanthanum strontium manganite (La₁₋ₓSrₓMnO₃) layer (e.g. La_{0.7}Sr_{0.3}MnO₃), e.g. a heterostructure of HfOₓ and La₁₋ₓSrₓMnO₃.

14. The method according to any of the preceding claims, wherein the second substrate is a CMOS-compatible substrate, for example a silicon substrate or silicon-oxide substrate, e.g. an oxide coated silicon substrate.

15. The method according to any of the preceding claims, wherein the memristor device layer is provided with one or more additional electronic circuit structures.

16. The method according to any of the preceding claims, wherein the second substrate is provided with one or more additional electronic circuit structures, that are connected to the memristor system, in particular to provide a neuromorphic memristor system.

17. The method according to any of the preceding claims, including:
- in a first processing space, for example a first cleanroom, depositing the epitaxial buffer layer on the first substrate and depositing of the at least one memristor device layer on the buffer layer;
- depositing at least one of the electrode structures in at least one second processing space, for example a second cleanroom;
wherein the first processing space and the second processing space are physically separate areas, the second processing space in particular being a CMOS-compatible cleanroom;
wherein preferably at least one airlock is arranged between the first processing space and the second processing space, wherein said freestanding layer is preferably transferred from the first processing space to the second processing space via the at least one airlock, for example using a sealed container.

18. Neuromorphic device including at least one memristor system manufactured by a method according to any of the preceding claims.
